# EUROPEAN PATENT APPLICATION

(11) **EP 1 651 020 A1**
(43) Date of publication of application: **26.04.2006**
(21) Application number: 04747168.5
(22) Date of filing: 01.07.2004
(51) Int. Cl.: H05K 3/34, H03B 5/30

(54) **PACKAGING ELECTRODE, PACKAGE, DEVICE AND PROCESS FOR PRODUCING DEVICE**

(30) Priority: 02.07.2003 JP 2003190441; 03.07.2003 JP 2003191154
(71) Applicant: SEIKO EPSON CORPORATION, Tokyo 160-0811 (JP)
(72) Inventor: SUGIURA, Tsuyoshi, c/o Seiko Epson Corporation, Suwa-Shi, Nagano 3928502 (JP)
(74) Representative: Hoffmann, Eckart
(86) International application number: PCT/JP2004/009699
(87) International publication number: WO 2005/004565

(57) **Abstract**

In the mounting pad provided on an insulating substrate and comprising an electrically conductive pattern electrically joining with an electronic component and/or a bonding wire connected to an electronic component, the electrically conductive pattern comprises a plurality of metalized layers stacked one another. By such structure, it can be prevented that an electrically conductive adhesive for joining electronic components with mounting pads flowing out from the joining section therebetween causes short-circuit of the mounting pads or interferes wire-bonding by covering the bonding area.

## Description

### Field of the Invention

The present invention relates to a mounting pad, a package, a device, and a fabrication process of the device, particularly to an electrically conductive pattern, a package, a device, and a fabrication process of the device suitable for preventing any problems caused by an electrically conductive joining material flowing out when joining electronic components by the electrically conductive joining material.

### Background

An example of the devices having surface-mounted components is a piezoelectric device. In an example of the piezoelectric device, there are formed on an insulating substrate in a package a mounting pad for mounting a piezoelectric vibrating element and a mounting pad for mounting an electronic component. Further, in another example of such a piezoelectric device, there are formed on an insulating substrate in a package a usual mounting pad and a mounting pad having a bonding area. In the former example, the piezoelectric vibrating element is mounted on the mounting pad and the electronic component is surface-mounted on the mounting pad. In the latter example, the piezoelectric vibrating element is mounted on the mounting pad and the electronic component is mounted on a part of the mounting pad except for the bonding area, and the electronic component and the bonding area of the mounting pad are connected with each other by wire-bonding. Further, the mounting pads are formed by plating metal on a single layer of a metalized layer formed by the thick film printing method. The piezoelectric vibrating element and the electronic component are joined with the mounting pads by the electrically conductive material such as, for example, an electrically conductive adhesive. In this bonding process, the electronic component is mounted after the electrically conductive adhesive is coated by transfer printing or a dispenser on the mounting pad.

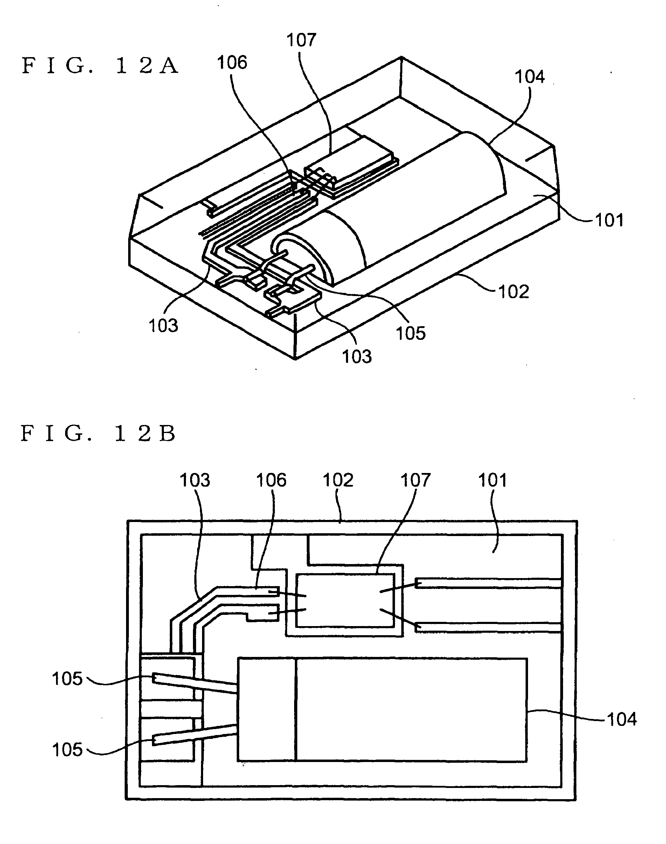

The latter example of the conventional examples described above, which uses wire-bonding, is described hereinafter along FIG. 12. FIG. 12A is a view for explaining a piezoelectric device according to Japanese unexamined patent publication No. 7-283653, and FIG. 12B is a view for explaining a piezoelectric device according to Japanese unexamined patent publication No. 2001-168640. These piezoelectric devices have structures in which a single layer of a metalized layer 103 is formed on a package base 102 which forms an insulating substrate 101, and a terminal 105 of a piezoelectric vibrator 104 is joined to a bonding area provided on the metalized layer 103 by the electrically conductive material, and further, the wire-bonding is provided from a bonding area 106 provided on the metalized layer 103 to a semiconductor integrated circuit 107 mounted on another electrically conductive pattern.

Incidentally, in recent years, downsizing and low-profiling of electronic apparatuses have been promoted, and accordingly, piezoelectric devices to be mounted on the electronic apparatuses are required to be downsized and low-profiled, which makes mounting pads be also downsized and the distances between the mounting pads be shortened. For example, some piezoelectric devices have distances of 0.4 mm between mounting pads and mounting pads in the bonding areas. In order to mount electronic components on such a downsized and low-profiled piezoelectric device, the electrically conductive adhesive is coated by transfer printing or a dispenser followed by joining the electronic components. However, since such a coating method is not suitable for controlling and managing the amount of the electrically conductive adhesive, it is troublesome and costly to coat a precise amount of the adhesive. Further, if too much amount of the electrically conductive adhesive is coated on the mounting pad, the electrically conductive adhesive flows out of the joining interface between the mounting pad and the joining electrode of the electronic component, which sometimes causes problems of short-circuits between the mounting pads or of covering the bonding area to interfere the wire-bonding. Further, the range of appropriate amount of the electrically conductive adhesive is too narrow to easily fabricate the products.

### Explanation of the short-circuit problem of the mounting pads

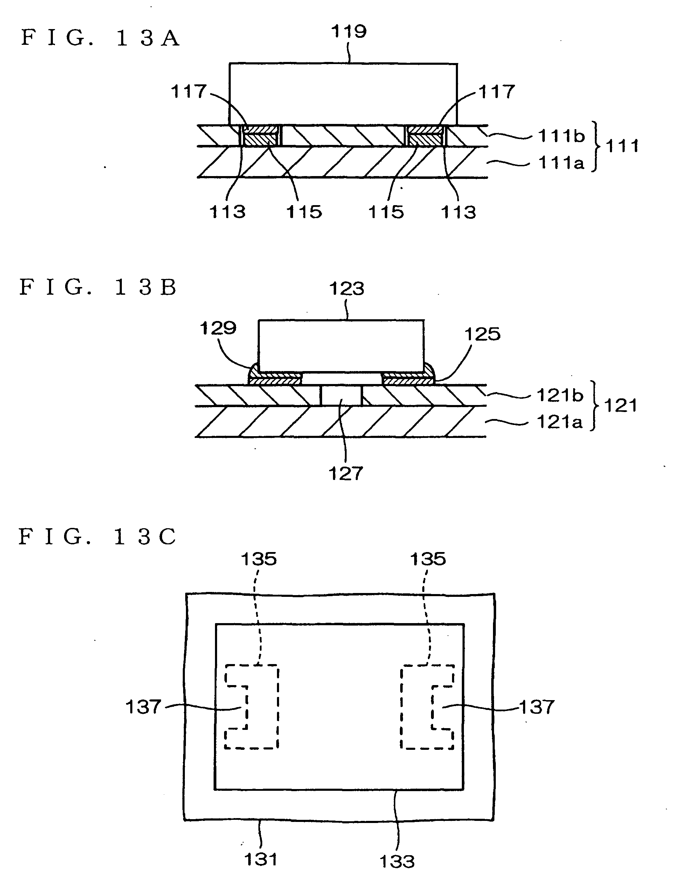

Firstly, the short-circuit problem of the mounting pads is explained. As shown in FIG. 13, a technology for preventing the mounting pads from short-circuiting with each other is proposed. FIG. 13 is a view for explaining a conventional technology for preventing the mounting pads from short-circuiting with each other.

In the first conventional technology, an insulating substrate 111 having hollow sections in a part thereof is formed by laminating a planar insulating substrate 111a with another planar insulating substrate 111b having openings in a part thereof. After forming mounting pads 115 lower than the depth of the hollow sections 113 in the hollow sections 113, an electronic component 119 is mounted on the mounting pads 115 via electrically conductive adhesive 117 (see FIG. 13A). By such structure, when the electronic component 119 is mounted, the electrically conductive adhesive 117 can be prevented from flowing over the step of the hollow section 113 into another hollow section 113, and thus preventing the short-circuit of the mounting pads 115 (Japanese unexamined patent publication No. 2000-244090).

Further, in the second conventional technology, a pair of mounting pads for mounting an electronic component 123 on an insulating substrate 121 is provided. The insulating substrate 121 is provided with a hollow section 127 adjacent to the pair of mounting pads 125. The insulating substrate 121 is formed by laminating a planar insulating substrate 121a with another planar insulating substrate 121b having an opening in a part thereof (see FIG. 13B.). By thus structuring, since the excessive part of the electrically conductive adhesive 129 flows into the hollow section 127 without flowing out around the mounting pads 125 when the electronic component 123 is joined to the mounting pads 125 with the electrically conductive adhesive 129, the short-circuit of the mounting pads 125 can be prevented (Japanese unexamined patent publication No. 11-261205).

Further, in the third conventional technology, a groove is formed on one side surface of a pole like piezoelectric vibrating element, and electrodes are formed on both sides of the groove. Supporting members formed of an electrically conductive material are provided in a center portion of the electrodes, namely, a center portion of the piezoelectric vibrating element in the length direction thereof. And, the piezoelectric device is formed by joining the supporting members to the mounting pads provided on the insulating substrate with the electrically conductive adhesive and then providing an insulating adhesive between the supporting members. By such structure, since the electrically conductive adhesive flowing out between the supporting members is blocked by the insulating adhesive, the short-circuit of the mounting pads is prevented (Japanese unexamined patent publication No. 11-112279).

Further, in the fourth conventional technology, a pair of mounting pads 135 for mounting the electronic component 133 is formed on an insulating substrate 131. The mounting pads 135 have notch sections 137 formed towards inside of the mounting pads 135 in an outer side opposite to the side on which the mounting pads face to each other (see FIG. 13C.). By such structure, since the excessive electrically conductive adhesive is pulled in to the notch sections 137 to be prevented from flowing out between the mounting pads 135 when the electronic component 133 is mounted on the mounting pads 135 having electrically conductive adhesive coated thereon, the short-circuit of the mounting pads 135 is prevented (Japanese unexamined patent publication No. 2000-138339).

However, in the inventions described in Japanese unexamined patent publication No. 2000-244090 and Japanese unexamined patent publication No. 11-261205, the insulating substrates need to be formed by laminating the planar insulating substrate with the planar insulating substrate provided with opening sections, which causes a problem of increasing the manufacturing cost and also manufacturing steps. Further, in the invention described in Japanese unexamined patent publication No. 11-112279, since the piezoelectric vibrating element is supported by joining members provided on the piezoelectric vibrating element, the shape of the supporting section of the piezoelectric vibrating element becomes complicated to cause a problem of making the manufacturing cost thereof higher than that of the conventional piezoelectric vibrating element or the like. Further, in the invention described in Japanese unexamined patent publication No. 2000-138339, since the notch sections are provided to the mounting pads, there is caused a problem of decreasing the area for bonding the electronic component to weaken the bonding strength therebetween.

### Explanation of a problem of covering the bonding areas

A problem of covering the bonding areas to interfere the wire-bonding is hereinafter described.

In order to mount electronic components on electrically conductive patters, an electrically conductive joining material is coated on a surface of a joining area provided on a single layer of a metalized layer by transfer printing or a dispenser, and then the electronic components are mounted to be joined. If the electronic component is mounted on the joining area after too much electrically conductive joining material is coated on the joining area, it is problematical that the electrically conductive joining material flows from the joining interface between the joining area and the electronic component along the electrically conductive pattern to cover the joining area or to make the part for wire-bonding extremely narrow.

And, in case the bonding area is covered with the electrically conductive joining material, it is problematical that wire-bonding is sometimes impossible, or, even if wire-bonding is possible, the reliability of the bonding varies depending on the purity of an alloy layer of a electrically conductive joining material formed between the bonding wire and the bonding area or on whether or not impurities enter. In other words, even if the bonding is successful, it a problem that the bonding strength between the bonding wire and the electrically conductive pattern is decreased arises, or a problem that the electrical conductivity is not maintained after ageing in spite of apparent bonding. Further, it is problematical that there is electrical resistance between the bonding wire and the bonding area and the capacity thereof varies even if there is enough strength.

Further, since the amount of the electrically conductive joining material is difficult to be controlled or managed in the method of coating the electrically conductive joining material using transfer printing or a dispenser, it is problematical that it is troublesome and costly to coat a precise amount thereof.

The present invention addresses the problems described above and has an object of providing a mounting pad, a package, a device and a fabrication method of the device, the mounting pad, the package, and the device having no short-circuit between the mounting pads and no coverage of the wire-bonding pads or the bonding areas even with a broadened tolerance level of the amount of electrically conductive adhesive used for joining an electronic component with the mounting pad except the bonding area, and thus easily fabricated with low costs.

### Disclosure of the Invention

A mounting pad according to the present invention is a mounting pad provided on an insulating substrate that comprises an electrically conductive pattern for electrically joining with an electronic component, the electrically conductive pattern comprising a plurality of metalized layers stacked one upon another.

Further, the electrically conductive pattern is larger than the area of the joining pad provided on an electronic component.

Further, the electrically conductive pattern is formed by stacking layers like a stair to form a pyramid-like shape.

Further, a side of the electrically conductive pattern, on which the mounting pads face each other, is formed by stacking layers like a stair.

Further, a side of the electrically conductive pattern, on which the mounting pads face each other, is formed by stacking layers with an aligned side face.

Further, the total thickness of stacked metalized layers is thicker than 40µm.

Further, the electrically conductive pattern comprises a bonding area for bonding a bonding wire, and a wire-bonding pad formed by stacking a metalized layer on the bonding area.

Further, the wire-bonding pad has a protruding section on the side facing a joining area for joining with the electronic component via an electrically conductive joining material.

Further, the electrically conductive pattern comprises a bonding area for bonding a bonding wire, a joining area for joining with the electronic component via an electrically conductive joining material, and a protrusion provided between the bonding area and the joining area for blocking the electrically conductive joining material flowing into the bonding area.

Further, the bonding area comprises a wire-bonding pad formed of stacked metalized layers.

Further, the wire-bonding pad has a protruding section on the side facing a joining area.

Further, the protrusion is formed to have a box-like shape with one side open other than the side facing the joining area.

Further, the protrusion is formed to have a protruding section towards the joining area.

A package according to the present invention comprises a mounting pad described above on a package base.

Further, the package base is made of ceramic.

A device according to the present invention comprises a package described above, wherein, an electronic component is joined, via an electrically conductive adhesive, with the mounting pad provided on the package base.

Further, the electrically conductive adhesive is one of an adhesive including an electrically conductive filler and a solder.

A device according to the present invention comprises a package described above, wherein an electronic component is joined with the joining area provided on the package base via an electrically conductive joining material, and wire-bonding is provided on one of the wire-bonding pad and the bonding area.

Further, the device described above is a piezoelectric device which comprises one of a piezoelectric vibrating element and a surface acoustic wave resonator.

A method of fabricating a device according to the present invention, comprises the step of forming a mounting pad having a electrically conductive pattern for joining an electronic component by stacking metalized layers on an insulating substrate, and the step of mounting an electronic component on the mounting pad via an electrically conductive adhesive.

Further, the step of forming a mounting pad comprises, a step of forming a wire-bonding pad by stacking metalized layers on a part of the electrically conducive pattern, and/or the step of forming a protrusion by metalizing between a joining area for joining with an electronic component and a bonding area for bonding a bonding wire, the step of mounting an electronic component comprises, the step of joining the electronic component with the joining area using an electrically conductive joining material, and the step of providing wire-bonding on a wire-bonding pad.

### Brief Description of the Drawings

- FIG. 1: is a view for explaining the plane shape of a mounting pad according to a first embodiment.
- FIG.2 2: is a view for explaining the plane shape of a mounting pad according to a first embodiment.
- FIG. 3: is a cross-sectional view of a piezoelectric vibrator.
- FIGS. 4A: through 4C are views for explaining a first through a third modified examples of a mounting pad according to a first embodiment.
- FIG. 5: is a view for explaining a fifth modified example of a mounting pad according to a first embodiment.
- FIG.6: is a view for explaining the plane shape of a bonding area according to a second embodiment.
- FIG. 7: is a view for explaining the side shape of an electrically conductive pattern according to a third embodiment.
- FIG. 8: is a view for explaining the plane shape of an electrically conductive pattern according to a third embodiment.
- FIGS. 9A: through 9C are views for explaining the plane shape of a wire-bonding pad according to a third embodiment.
- FIG. 10: is a cross-sectional view of a piezoelectric vibrator.
- FIGS. 11A through 11C: are views for explaining the plane shape of a wire-bonding area according to a fourth embodiment.
- FIGS. 12A and 12B: are views for explaining a piezoelectric device according to a conventional technology.
- FIGS. 13A through 13C: are views for explaining a conventional technology for preventing mounting pads from short-circuiting with each other.

### Description of the Preferred Embodiment

A mounting pad, a package, a device, and a fabrication method of the device according to the present invention are hereinafter described. Note that what is described below is nothing more than one embodiment of the present invention, and accordingly, the present invention is not limited thereto.

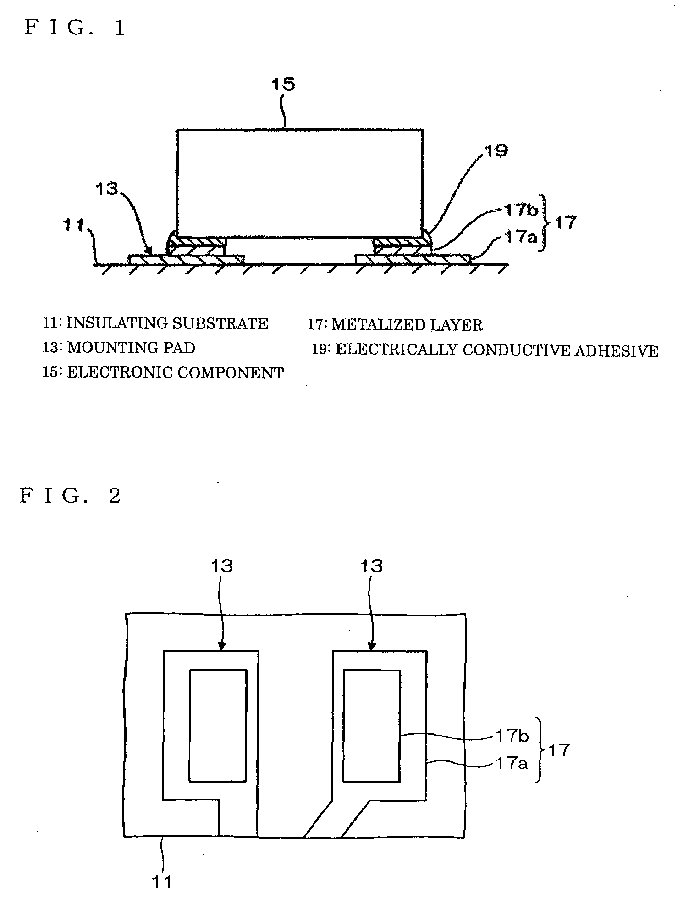

Firstly, a first embodiment is described. FIG. 1 shows a view for explaining the side shape of a mounting pad according to the first embodiment, and FIG. 2 shows a view for explaining the plane shape of the mounting pad. Mounting pads 13 composed of electrically conductive patterns for electrically joining an electronic component 15 are formed on an insulating substrate 11 made of ceramics or resin. The mounting pads 13 are formed in accordance with joining pad (not shown in the drawing) formed on the bottom surface of the electronic component 15, and have structures in which a metallic thin film (not shown in the drawings) is formed on a pyramid like metalized layer 17 stacked like a stair to provide a space between a surface of the insulating substrate 11 and the bottom surface of the electronic component 15.

The metalized layer 17 is composed of two layers, namely, a first metalized layer 17a formed on the insulating substrate 11 and a second metalized layer 17b formed thereon and having a surface area smaller than that of the first metalized layer 17a and equal to or larger than the surface area of the joining pad. Note that the metalized layer 17 is not limited to the two layer structure, but can have any number of layers stacked in accordance with the use condition.

And, the metalized layer 17 is metalized by the thick film printing method or the deposition method to form a metalized layer made of metal such as, for example, tungsten or molybdenum as the metalized layer 17. The thickness of the metalized layer is, for example, about 20µm, and the total thickness becomes about 40µm if the metalized layer is composed of two stacked layers. Further, the metallic thin film is formed by plating or the like, for example, it is formed by gold plating on a surface with nickel plating.

When the electronic component 15 is mounted on such mounting pads 13, an electrically conductive adhesive 19 as the electrically conductive joining material is coated on the metallic thin film of the mounting pad 13 by transfer printing or a dispenser, prior to mounting and then joining the electronic component 15. The electronic component 15 belongs to a surface mounting type, and the type of component can be selected dependent on the type of device in, for example, resistors, capacitors, inductors, or varicaps. Further, an adhesive including an electrically conductive filler such as silver, gold, aluminum, or nickel can be used as the electrically conductive adhesive 19, and the material of the filler can be selected taking the material of the metallic thin film into consideration. Further, solders can also be used instead of the adhesives including the filler.

Still further, since the surface area of the metallic thin film is greater than the surface area of the joining pad, a side fillet can be formed on the side surface of the joining pad by forming the mounting pads 13 so that the metallic thin film runs off the joining pad to the outer side of the electronic component 15. The joining condition between the mounting pad 13 and the joining pad of the electronic component 15 can easily be checked from the external appearance using the side fillet.

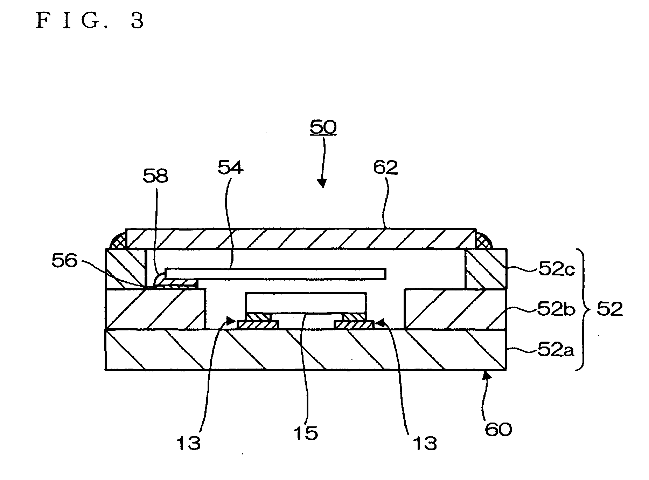

A device having a plurality of electronic components mounted inside the package can be obtained by forming thus structured mounting pads 13 on a base section of the ceramic package. In particular, a piezoelectric device can be formed by mounting a piezoelectric vibrating element or a surface acoustic wave resonator inside the package, and further, a piezoelectric oscillator can be formed by mounting a semiconductor integrated circuit or the like in addition to the piezoelectric vibrating element. A cross-sectional view of a piezoelectric oscillator is shown in FIG. 3. A package base 52 of the piezoelectric oscillator 50 is formed by stacking a number of frame-like ceramic insulating substrates 52b, 52c having different frame width form each other on a plane ceramic insulating substrate 52a. The mounting pads 13 described above are provided on a lower step inside the package base 52, and the electronic component 15 is mounted on the mounting pads 13. Further, mounting pads 56 for mounting a piezoelectric vibrating element 54 is formed on the middle step, on which the piezoelectric vibrating element 54 is mounted via an electrically conductive adhesive 58. And, a lid 62 for sealing the package 60 is bonded on the upper step thereof, and thus, the piezoelectric oscillator 50 is structured as described above. Note that the mounting pads 56 can also be formed, as is the case with the mounting pads 13, by stacking metalized layers.

Further, the mounting pads 13, thus structured, can be used for joining electronic components surface-mounted on insulating substrates such as print circuit boards or hybrid integrated circuits.

Since the mounting pad 13 adopts such a structure and is formed of the laminated metalized layer 17, the distance between the surface of the insulating substrate 11 and the electronic component 15 can be made larger. Therefore, since the large distance is provided between the surface of the insulating substrate 11 and the electronic component 15, an effect of the surface tension force acting between the insulating substrate 11 and the electronic component 15 bonded on the mounting pads 13 becomes very little, which can prevent the electrically conductive adhesive 19 coated between one of the mounting pads 13 and the joining pads from flowing out towards the other of the mounting pads 13.

Further, if too much amount of the electrically conductive adhesive 19 is coated on one of the mounting pads 13 to cause the electrically conductive adhesive 19 to overflow from the joining interface between the joining pads of the electronic component 15 and the mounting pads 13, the large distance minimizes the effect of the surface tension force to prevent the electrically conductive adhesive 19 from flowing out towards the other of the mounting pads 13. Therefore, the portion of the electrically conductive adhesive overflowing from one of the mounting pads 13 is cured around the one of the mounting pads 13 but does not flow out towards the other of the mounting pads 13.

Thus, the electrically conductive adhesive 19 with large tolerance in coating amount can be used, and accordingly, the electrically conductive adhesive 19 can be coated by conventional transfer printing or a conventional dispenser.

Therefore, the electrically conductive adhesive 19 flowing out of one of the mounting pads 13 does not contact the other of the mounting pads 13, thus preventing the short-circuit of the mounting pads 13.

Further, since the surface area of the second metalized layer is equal to or larger than the surface area of the joining pad provided on the electronic component, the strength of surly joining the mounting pads with the electronic component can be maintained.

Further, since the short-circuit of the mounting pads 13 can be prevented only by increasing the thickness of the metalized layer 17, any deformations added to the mounting pads, such as notches are not necessary. Accordingly, the area of joining necessary for joining the mounting pad 13 and the electronic component 15 with enough strength can be reserved.

In the present embodiment, since the short-circuit of the mounting pads 13 can be prevented only by stacking the metalized layer 17 on the single layered insulating substrate 11 to form the mounting pads 13, the fabrication process can be simplified and the fabrication cost can be lowered compared to the conventional technologies. Further, the reliability of the device can also be enhanced. Note that the insulating substrate 11 is not limited to be single layered, but the mounting pads can be provided on the insulating substrate formed by stacking a plurality of plane insulating substrates in accordance with an intended use of the device.

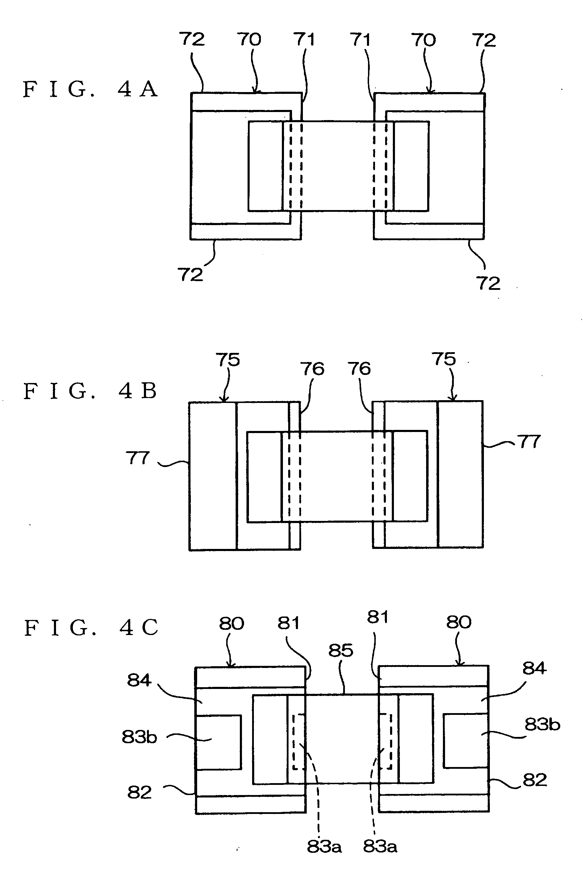

Further, the shape of the mounting pad 13 is not limited to the pyramid shape, but other shapes can be adopted. FIG. 4 shows a modified example of the mounting pads 13. In a first modified example shown in FIG. 4A, side surfaces 71, on which mounting pads 70 face each other, and lateral side surfaces 72, which position laterally with respect to the side surfaces 71, are formed like stairs. Further, in a second modified example shown in FIG. 4B, side surfaces 76, on which mounting pads 75 face each other, and rear side surfaces 77, which position opposite to the side surfaces, are formed like stairs. Further, in a third modified example shown in FIG. 4C, side surfaces 81, on which mounting pads 80 face each other, and rear side surfaces 82, which position opposite to the side surfaces, are provided with hollow sections 83a, 83b formed in the second metalized layer 84 towards the inside of the mounting pads 80. And, the hollow section 83a provided on the side, on which the mounting pads 80 face each other, is provided under an electronic component 85 to be mounted on the mounting pads 80, and extends in front of a portion where the joining pads (not shown in the drawings) of the electronic component 85 and the mounting pad 80 are bonded with each other. Further, the hollow section 83b provided on the rear side surface 82 is formed so as to extend in front of the portion where the joining pads of the electronic component 85 and the mounting pad 80 are bonded with each other. Since the hollow sections 83a, 83b are not provided on the mounting surface where the mounting pads 80 and the electronic component 85 are bonded with each other, the joining strength of the mounting pads 80 and the electronic component 85 is not weakened.

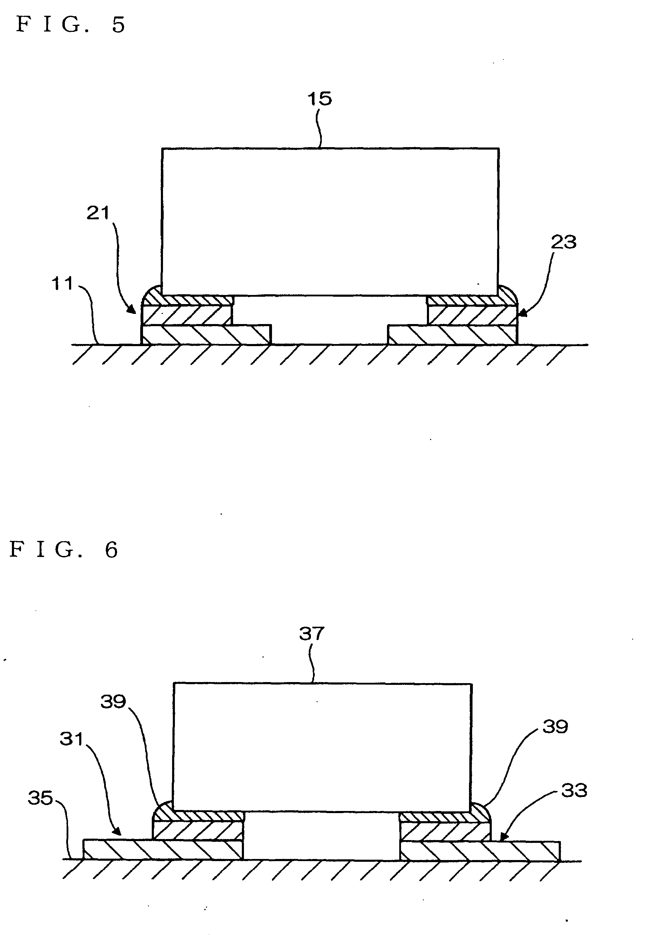

FIG. 5 shows a fifth modified example of the mounting pads. In the fifth modified example of the mounting pads 21, only the metalized layer on the surface, across which the mounting pads 21 face each other, is formed like a stair. In case the mounting pads 21 face each other, namely the electronic component 15 is mounted on the insulating substrate 11 with a plurality of mounting pads 21, the metalized layer 23 of the mounting pads 21 is enough to be stacked so that the facing surfaces are formed like stairs and other portions can be formed to have the same structure as the pyramid-like mounting pads 13.

A second embodiment is hereinafter described. Since the second embodiment differs from the first embodiment only in the shape of the mounting pad, the different portion only will be described and the description regarding the common portion will be omitted. FIG. 6 is a view for explaining the side shape of the mounting pad according to the second embodiment. The mounting pad 31 is structured so as to provide a space between the surface of an insulating substrate 35 and the bottom surface of the electronic component 37 by stacking metalized layers 33 so that the side surfaces facing each other are aligned, and then forming a metallic thin film (not shown in the drawings). The thickness of the metalized layer 33 is, for example, about 20µm per single layer, and the total thickness becomes about 40µm in case the metalized layer is composed of two stacked layers. The metalized layer 33 can be formed by stacking a number of metalized layers in accordance with the condition of use.

According to the above configuration, since the mounting pad 31 is formed of the laminated metalized layer 33, the distance between the surface of the insulating substrate 35 and the electronic component 37 can be made larger. Further, since the large distance is provided between the surface of the insulating substrate 35 and the electronic component 37, an effect of the surface tension force acting between the insulating substrate 35 and the electronic component 37 bonded on the mounting pads 31 becomes very little, which can prevent the electrically conductive adhesive 39 coated on one of the mounting pads 31 from flowing out towards the other of the mounting pads 31. Further, if too much amount of the electrically conductive adhesive 39 for joining the electronic component 37 with the mounting pads 31 is coated, and the electrically conductive adhesive 39 runs off from the joining interface between the joining pads (not shown in the drawings) of the electronic component 37 and mounting pads 31, the large space described above minimizes the effect of the surface tension force. Further, since the metalized layers 33 are stacked with the side surfaces thereof aligned, the capacity of a space defined by the surface of the insulating substrate 35, the bottom surface of the electronic component 37, and the side surfaces of the mounting pads 31 is larger in comparison with the first embodiment, the electrically conductive adhesive running off the joining interface is cured in the closer area to the mounting pads and dose not flow out towards the other of the mounting pads 31. Thus, the electrically conductive adhesive 39 with large tolerance in coating amount can be used, while preventing the shot-circuit of the mounting pads 31.

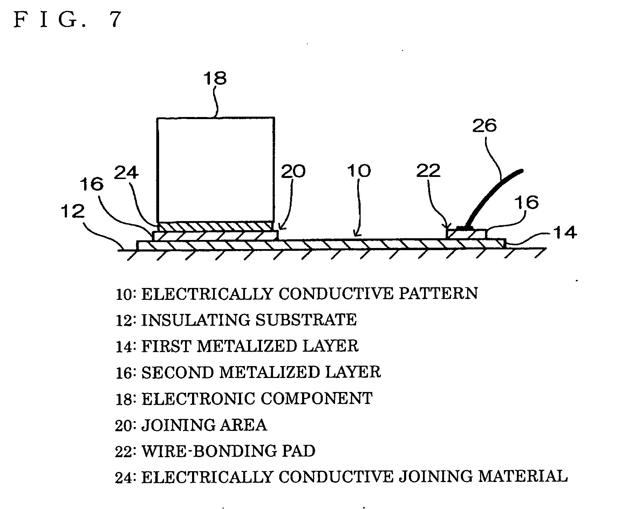

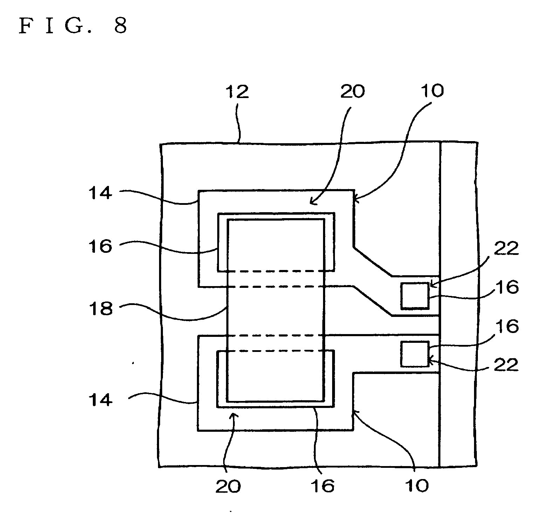

A third embodiment is hereinafter described. FIG. 7 shows a side view of an electrically conductive pattern according to the third embodiment, and FIG. 8 shows a plan view of the electrically conductive pattern. The electrically conductive pattern 10 is composed mainly of a first metalized layer 14 formed on the insulating substrate 12 and a second metalized layer 16 formed on a part of the first metalized layer 14.

The first metalized layer 14 has a structure formed by metalizing with a metal such as tungsten or molybdenum using the thick film printing method. And, a joining area 20 for joining the electronic component 18 and a wire-bonding pad 22 for pressure-bonding a bonding wire 26 are provided on the upper surface of the first metalized layer 14. The joining area 20 and the wire-bonding pads 22 are formed in accordance with the layout of the electronic components 18 or the like to be bonded.

The wire-bonding pad 22 is structured by stacking the second metalized layer 16 on a part of the upper surface of the first metalized layer 14, where the wire-bonding is provided, and then forming a metallic thin film (not shown in the drawings) on the upper surface of the second metalized layer 16. The second metalized layer 16 is formed in the same manner as the first metalized layer 14. In this case, the thickness of the second metalized layer 16 can be adjusted if necessary taking the distance from the joining area 20 or the thickness of the electrically conductive joining material 24 flowing from the joining area 20 into consideration. Further, the metallic thin film is formed by, for example, gold plating on a surface with nickel plating.

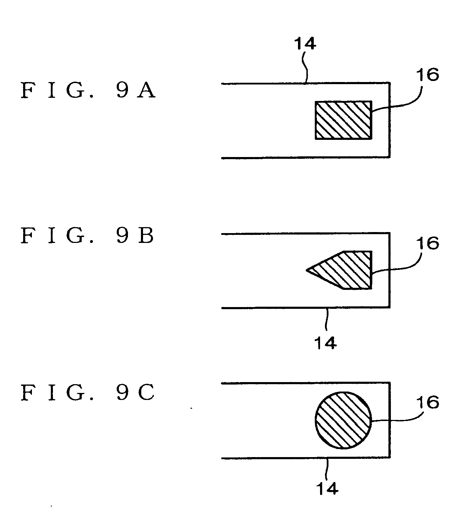

Further, any shapes of wire-bonding pads 22 can be adopted. FIG. 9 shows schematic views for explaining plane shapes of the wire-bonding pad 22. The second metalized layer 16 formed on the first metalized layer 14 can be shaped as, for example, a rectangle (FIG. 9A), a pentagon formed to have a protrusion on the side of the joining area to which the electronic component 18 is bonded (FIG. 9B), or a circle (FIG. 9C), thus the wire-bonding pad 22 is formed.

The joining area 20 is structured by stacking the second metalized layer 16 on a part of the upper surface of the first metalized layer 14, where the electronic component 18 is bonded, and then forming a metallic thin film (not shown in the drawings) on the second metalized layer 16. This can be formed in the same manner as the wire-bonding pad 22. Further, the joining area 20 can also be structured by providing a metallic thin film directly on the first metalized layer 14.

And further, in order to bond the electronic component 18 on the electrically conductive pattern 10, the electronic component 18 is mounted and then bonded after coating the electrically conductive joining material 24 on the joining area 20 using transfer printing or a dispenser. When coating the electrically conductive joining material 24 using the transfer printing of the dispenser, too much amount of the electrically conductive joining material 24 is sometimes coated thereon because it is difficult to control the amount of coating. In this case, although the electrically conductive joining material 24 flows out from the joining interface between the joining area 20 and the electronic component 18 along the electrically conductive pattern 10 towards the wire-bonding pad 22, the electrically conductive joining material cannot climb over the second metalized layer 16 to cover the surface of the wire-bonding pad 22 because the second metalized layer 16 is thicker than the electrically conductive joining material flowing therefrom. Note that the electronic component 18 can be selected to be mounted dependent on the type of devices in, for example, resistors, capacitors, inductors, or varicaps.

Further, when wire-bonding on the wire-bonding pad 22, the bonding wire 26 is pressure-bonded using a bonding machine or the like.

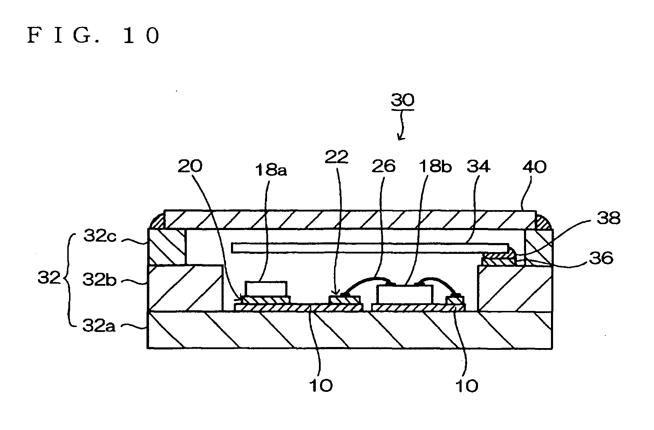

A device having a plurality of electronic components 18 mounted inside the package can be obtained by forming a thus structured electrically conductive pattern 10 on a package base made of ceramic or the like. Further, a piezoelectric device can be formed by mounting a piezoelectric vibrating element or a surface acoustic wave resonator inside the package, and further, a piezoelectric oscillator can be formed by mounting a semiconductor integrated circuit or the like in addition to the piezoelectric vibrating element. A cross-sectional view of a piezoelectric oscillator is shown in FIG. 10. A package base 32 of the piezoelectric oscillator 30 is formed by stacking a number of frame-like ceramic insulating substrates 32b, 32c having frame widths different from each other on a plane ceramic insulating substrate 32a. A plurality of the electrically conductive patterns 10 described above is formed on the lowermost step inside the package base 32, and the electronic components 18a are bonded on the joining area 20 on the electrically conductive pattern 10 using the electrically conductive joining material. Further, the bonding wire 26 for connecting to another electronic component 18b is bonded on the wire-bonding pad 22. Still further, the mounting pads 36 for mounting the piezoelectric vibrating element 34 are formed on the middle step of the package base 32, on which the piezoelectric vibrating element 34 is bonded using the electrically conductive joining material 38. A lid 40 for sealing the inside of the package base 32 is bonded on the upper step thereof. The piezoelectric oscillator 30 is formed of such a configuration.

According to the configuration, since the wire-bonding pad 22 is formed by stacking the second metalized layer 16 on the first metalized layer 14, the surface of the wire-bonding pad 22 can be formed at a higher position than the upper surface of the first metalized layer 14. And, if the electrically conductive joining material 24 for joining the joining area 20 with the electronic component 18 flows out along the electrically conductive pattern 10, the electrically conductive material does not climb over the second metalized layer 16 to cover the surface of the wire-bonding pad 22 because the surface of the wire-bonding pad 22 is positioned higher than the electrically conductive joining material flowing out with a thickness not enough to climb over the wire-bonding pad surface.

Further, if too much amount of the electrically conductive joining material 24 is coated on the joining area 20, the wire-bonding pad 22 is not covered by the electrically conductive joining material 24 that flows out, thus the electrically conductive joining material 24 can be used with large tolerance in coating amount. Therefore, wire-bonding can be executed on the wire-bonding pad 22 irrespective of coating amount of the electrically conductive joining material 24 or the distance between the joining area 20 and the wire-bonding pad 22.

Further, since the electrically conductive joining material 24 can be prevented from covering the surface of the wire-bonding pads 22 only by providing the second metalized layer 16 on the first metalized layer 14, it can be fabricated with ease and a low cost.

Further, if the second metalized layer 16 is formed as a pentagon with a protrusion in the side of the electronic component 18 or a circle (see FIG. 9), the electrically conductive joining material flows out along the electrically conductive pattern 10 can be separated from side to side with a low resistance, thus preventing the surface of the wire-bonding pad 22 from being covered with the electrically conductive joining material 24.

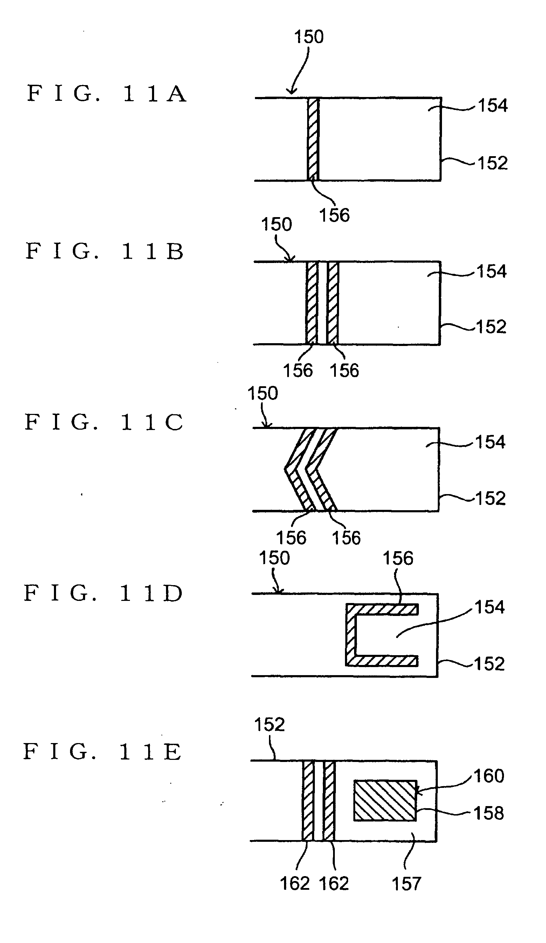

A fourth embodiment is hereinafter described. FIG. 11 shows a plan view of an electrically conductive pattern according to the fourth embodiment. Note that the drawing shows only the adjacent area of the bonding area. The electrically conductive pattern 150 is structured by forming the first metalized layer 152 mainly on an insulating substrate (not shown in the drawings), and forming a joining area (not shown in the drawings) and bonding area 154 on the upper surface of the first metalized layer 152, and forming a metallic thin film (not shown in the drawings) on the areas.

A protrusion 156 traversing the first metalized layer 152 in the width direction is provided on the first metalized layer 152 and between the joining area and the bonding area 154 to separate the joining area side and the bonding area side. One or more of the protrusions 156 can be provided, and the shape can be modified to a straight line or a shape having a protrusion towards the joining area (see FIGS. 11A through 11C.). The number of the protrusions 156 provided on the first metalized layer 152 can be decided depending on the distance between the joining area and the bonding area or the amount of the electrically conductive joining material. Note that, in case the distance between the joining area and the bonding area is short, or the amount of the electrically conductive joining material is large, a plurality of protrusions preferably be provided. Further, the protrusion 156 can be shaped like a box with one side opposite to the joining area (right hand in the drawing) opened, which substantially encloses the bonding area 154 (see FIG. 11D). Since the box-shaped protrusion 156 has one side open, the bonding wire can be pressure-bonded by the bonding machine without damaging the bonded bonding wire.

The height of such a box-shaped protrusion 156 can be adjusted taking the distance from the joining area and the height of the electrically conductive joining material flowing from the joining area into consideration.

The first metalized layer 152 and the protrusion 156 of the electrically conductive pattern 150 thus structured can be formed by metalizing metal such as for example tungsten or molybdenum using the thick film printing method or the like. Further, the metallic thin film is formed by, for example, gold plating on a surface with nickel plating.

Further, the electrically conductive pattern 150 can be provided on the package base made of ceramic or the like to form the package. Further, a piezoelectric device can be formed by mounting a piezoelectric vibrating element or a surface acoustic wave resonator on the package base. Note that the package and the piezoelectric device can be fabricated in a manner similar to the third embodiment.

According to the configuration, the bonding area 154 is separated from the joining area side by the protrusion 156 provided on the first metalized layer 152. Therefore, if the electrically conductive joining material for joining the electronic component (not shown in the drawings) with the joining area flows out along the electrically conductive pattern 150, the protrusion 156 functions as a barrier to prevent the electrically conductive joining material from flowing into the bonding area 154. Further, if too much amount of the electrically conductive joining material is coated on the joining area, the bonding area 154 is not covered by the electrically conductive joining material that flows out, thus the electrically conductive joining material can be used with large tolerance in coating amount. Therefore, wire-bonding can be executed on the bonding area 154 irrespective of the coating amount of the electrically conductive joining material or the distance between the joining area and the bonding area 154.

Further, since the electrically conductive joining material can be prevented from flowing into the bonding area 154 only by providing the protrusion 156 on the first metalized layer 152 by metalization, it can be fabricated with ease and a low cost.

Note that an electrically conductive adhesive composed of a resin base and a electrically conductive filler, solder, or the like can be used as the electrically conductive joining material.

In the fourth embodiment, the protrusion 156 is provided on the first metalized layer 152, however, an alternative structure is possible, in which the second metalized layer 158 described in the third embodiment is stacked on the bonding area 157 which is an area on the first metalized layer 152 and provided with no metallic thin film, and then the metallic thin film (not shown in the drawings) is also formed to form the wire-bonding pad 160. And, the structure can be taken in which the protrusion 162 described above is provided between the wire-bonding pad 160 and the joining area (see FIG. 11E.). In this configuration, the electrically conductive joining material flowing along the first metalized layer 152 can be stopped by the protrusion 162, and if the electrically conductive joining material flows beyond the protrusion 162, since the surface of the wire-bonding pad 160 is positioned higher than the thickness of the electrically conductive joining material, the surface of the wire-bonding pad 160 is not covered with the electrically conductive joining material. Note that the shapes described in the third embodiment can be applied to the wire-bonding pads 160, and the shapes described in the fourth embodiment can be applied to the protrusion 162.

## Claims

1. A mounting pad provided on an insulating substrate, comprising:
an electrically conductive pattern for electrically joining with an electronic component, the electrically conductive pattern comprising a plurality of metalized layers stacked one upon another.

2. The mounting pad according to Claim 1, wherein the electrically conductive pattern is larger than a joining pad provided on the electronic component.

3. The mounting pad according to any one of Claims 1 and 2, wherein the electrically conductive pattern is formed by stacking layers like a stair to form a pyramid-like shape.

4. The mounting pad according to any one of Claims 1 and 2, wherein a side of the electrically conductive pattern, on which the mounting pads face each other, is formed by stacking layers like a stair.

5. The mounting pad according to any one of Claims 1 and 2, wherein a side of the electrically conductive pattern, on which the mounting pads face each other, is formed by stacking layers with an aligned side face.

6. The mounting pad according to any of Claims 1 through 5, wherein the total thickness of stacked metalized layers is larger than 40µm.

7. The mounting pad according to Claim 1, wherein the electrically conductive pattern comprises:
a bonding area for bonding a bonding wire; and
a wire-bonding pad formed by stacking a metalized layer on the bonding area.

8. The mounting pad according to Claim 7, wherein the wire-bonding pad has a protruding section on the side facing a joining area for joining with the electronic component via an electrically conductive joining material.

9. The mounting pad according to Claim 1, wherein the electrically conductive pattern comprises:
a bonding area for bonding a bonding wire;
a joining area for joining with the electronic component via an electrically conductive joining material; and
a protrusion provided between the bonding area and the joining area for blocking the electrically conductive joining material flowing into the bonding area.

10. The mounting pad according to Claim 9, wherein the bonding area comprises a wire-bonding pad formed of stacked metalized layers.

11. The mounting pad according to Claim 10, wherein the wire-bonding pad has a protruding section on the side facing a joining area.

12. The mounting pad according to any of Claims 9 through 11, wherein the protrusion is formed to have a box-like shape with one side open other than the side facing the joining area.

13. The mounting pad according to any of Claims 9 through 11, wherein the protrusion is formed to have a protruding section towards the joining area.

14. A package comprising a mounting pad according to any of Claims 1 through 13 on a package base.

15. The package according to Claim 14, wherein the package base is made of ceramic.

16. A device comprising a package according to any one of Claims 14 and 15, wherein, an electronic component is joined, via an electrically conductive adhesive, with the mounting pad provided on the package base.

17. The device according to Claim 16, wherein the electrically conductive adhesive is one of an adhesive including an electrically conductive filler and a solder.

18. A device comprising a package according to any one of Claims 14 and 15, wherein an electronic component is joined with the joining area provided on the package base via an electrically conductive joining material, and wire-bonding is provided on one of the wire-bonding pad and the bonding area.

19. The device according to any one of Claims 16 through 18, comprising one of a piezoelectric vibrating element and a surface acoustic wave resonator.

20. A method of fabricating a device, comprising:
forming a mounting pad having an electrically conductive pattern for joining an electronic component by stacking metalized layers on an insulating substrate; and
mounting an electronic component on the mounting pad via an electrically conductive adhesive.

21. The method of fabricating a device according to Claim 20, wherein the step of forming a mounting pad comprises:
forming a wire-bonding pad by stacking metalized layers on a part of the electrically conducive pattern; and/or
forming a protrusion by metalizing between a joining area for joining with an electronic component and a bonding area for bonding a bonding wire; and
the step of mounting an electronic component comprises:
joining the electronic component with the joining area using an electrically conductive joining material; and
providing wire-bonding on a wire-bonding pad.
